# EUROPEAN PATENT SPECIFICATION

(11) **EP 3 331 330 B1**
(45) Date of publication and mention of the grant of the patent: **06.07.2022**
(21) Application number: 16382586.2
(22) Date of filing: 02.12.2016
(51) Int. Cl.: H05K 1/02, H05K 1/05, H05K 3/44, H05K 3/40, H05K 3/42, H05K 1/11

(54) **ELECTRICAL CONNECTION IN AN IMS PCB BY FORMING AN OPENING IN DIELECTRIC LAYER**
ELEKTRISCHE VERBINDUNG IN EINER IMS-LEITERPLATTE DURCH EINE ÖFFNUNG IN DER DIELEKTRISCHEN SCHICHT
CONNEXION ÉLECTRIQUE DANS UNE PCB IMS PAR FORMATION D'UNE OUVERTURE DANS LA COUCHE DIÉLECTRIQUE

(43) Date of publication of application: 06.06.2018
(73) Proprietor: VALEO ILUMINACION, 23600 Martos (ES)
(72) Inventor: ROLDAN, Jose-David, 23680 Alcalá la Real (ES); LARA-CABEZA, Juan, 23009 Jaen (ES); SANTAELLA, Juan-Jose, 18101 Belicena (ES); PENA, Miguel-Angel, 18260 ILLORA (ES); ILLAN, Antonio Domingo, 23600 MARTOS (ES)
(74) Representative: Valeo Visibility

(56) References cited:
- DE-A1- 10 335 805
- DE-A1-102012 223 287
- US-A1- 2009 314 650
- US-B1- 6 700 748
- "HIGH EFFICIENCY RADIATION HOLE WITH METAL CORE PRINTED WIRING BOARD", IBM TECHNICAL DISCLOSURE BULLETIN, INTERNATIONAL BUSINESS MACHINES CORP. (THORNWOOD), US, vol. 33, no. 7, 1 December 1990 (1990-12-01), pages 48-51, XP000108415, ISSN: 0018-8689

## Description

### TECHNICAL FIELD

The present invention relates to the field of electrical devices comprising an insulated metal substrate (IMS) printed circuit board (PCB). More particularly, the invention relates to performing an electrical connection between different electrically conductive layers of the IMS PCB. The electrical devices according to the present invention may be electrically connected to lighting devices, particularly lighting devices for a motor vehicle.

### STATE OF THE ART

Printed circuit boards are essential components of electronic systems as (part of or the entirety of) the electronic circuits and components necessary for implementing a desired functionality are hosted and interconnected thereon.

There are different kinds of printed circuit boards available on the market, each of which may be suitable for a particular range of applications. Among these, metal core printed circuit boards (MCPCBs) may be suitable for electronic systems such as lighting devices.

MCPCBs generally include an electrically conductive layer, at least one insulating layer, and a metallic substrate. Depending on the materials used in these layers and substrate, and depending on the manufacturing of the printed circuit board, the printed circuit boards may be adapted to dissipate heat, and thus be regarded as IMS PCBs. Typically, the metallic substrate of an IMS PCB is made up of aluminum or copper since these metals feature a good trade-off between thermal conductivity and cost.

Referring to PCBs in general, a common situation is that electronic components mounted on a first electrically conductive layer (or on a solder mask thereon) must be electrically connected to a selected part of a second electrically conductive layer (with a different electric potential, for example a ground potential) of the same circuit board. The first and second electrically conductive layers may be separated by an insulating layer made up of dielectric material, thus an electrically conductive element must be provided therewith in order to connect an electronic component to the selected part of the second electrically conductive layer.

Generally, in IMS PCBs, the electrically conductive element performing an electrical connection between two separate layers is, for example, a conductive spring, a screw, a wire, or a conductive foam. This means that additional components are necessary to provide the electrical connection, something which in mass production is disadvantageous as the production incurs in further costs. Moreover, these electrically conductive elements often establish the electrical connection only by physical contact between the electronic components and the electrically conductive layers, that is, they are not adhered to the conductive layers. Therefore, the connection may not be completely reliable since during the operation of the electronic system, the printed circuit board and/or the aforementioned conductive elements may move, or even oxidize, and get electrically disconnected.

Although not related with this technical problem, document DE 10 2012 223287 A1 discloses a circuit board with an electrically conducting core partially coated with an electrically insulated layer. The insulated layer has electrical strip conductors on a side that is turned away from the core, where the conductors contact electronic elements. The insulated layer has openings for guiding an electrical and/or thermal connection unit such that an electrically conducting connection is formed between the core and the conductors or between the core and the elements. The core and/or the connection unit and/or the conductors are partially made from copper.

Accordingly, there is an interest in providing electrical connections of a selected part of an electrically conductive layer of an IMS PCB to a selected part of another electrically conductive layer of the same IMS PCB, wherein said another layer may be the metallic substrate of the circuit board, that is both cost-effective and reliable.

### DESCRIPTION OF THE INVENTION

A first aspect of the invention relates to an electrical device for a lighting device as set forth in claim 1.

The electrically conductive material makes an electrical connection between the metallic substrate and one or more electrically conductive tracks (of the electrically conductive layer) via the hole that at least traverses the at least one electrically insulating layer of the circuit board. In this way, one or several electrically conductive tracks may be electrically connected to the metallic substrate and, thus, be at the same electrical potential.

With an electrical device as just defined, a fairly simple and cheap way of reliably connecting the metallic substrate with one or more of the electrically conductive tracks is achieved and which does not require any additional component (such as screws, bolts or springs).

The electrically conductive material is attached to the electrically conductive layer, particularly to the track(s) which are to be electrically connected to the metallic substrate, so that a reliable connection may be provided. As such, the electrical connection is not prone to disconnection upon manipulation of the electrical device, or upon suffering an impact hit, for example.

Since at least part of the electrically conductive material is within the hole, the conductive material may be fully integrated within the printed circuit board. This means that the electrically conductive material may be included in the printed circuit board and not protrude from it, so an imaginary box with sides tangential to those of the electrical device may feature the same size regardless of the presence of the electrically conductive material (i.e. the volume of the imaginary box does not increase). Further, in some embodiments, the entire electrically conductive material is within the hole.

The hole may be formed in the printed circuit board by milling, or by any other manufacturing technique for removing electrically insulating layer known in the art. The cross-section of the hole or, in other words, the contour of the holed area, may feature a polygonal (e.g. triangular, square, rectangular, etc.), circular, elliptic, or irregular shape.

The printed circuit board of the electrical device may comprise several holes within which at least part of an electrically conductive material is hosted. Each conductive material provides an electrical connection between the metallic substrate and selected electrically conductive track(s) of the electrically conductive layer.

A selected electrically conductive track of the electrically conductive layer may be connected to the metallic substrate with more than one electrical path. That is, the printed circuit board may comprise two or more holes with respective electrically conductive materials, and each electrically conductive material being adhered to the selected track and connecting it to the metallic substrate.

In some embodiments, the electrically conductive material comprises solder paste. The solder paste may be provided at the same time that solder paste is added to the electrically conductive layer (or solder mask attached to it, if there is any) for soldering electronic components to the printed circuit board. A reflow soldering process may then melt the solder paste and, as a result, the solder paste adheres to the electrically conductive layer.

As the electrically conductive material reaches the metallic substrate (by means of the hole), the electrical connection may be completed. In this regard, in the embodiments in which the metallic substrate of the printed circuit board comprises aluminum, the solder paste once melted may not adhere to the substrate but at least it is contact with it. However, in other embodiments, the electrically conductive material is further adhered to the metallic substrate. In these other embodiments, the metallic substrate preferably comprises copper.

Further, a surface finish treatment for PCBs as those known in the art is applied to the printed circuit board of the electrical device, and when an electrically conductive PCB finishing is applied to the PCB, e.g. HASL (hot air solder leveling), ENIG (electroless nickel immersion gold), immersion tin, etc., the electrically conductive material comprises a layer produced by said electrically conductive PCB finishing.

The electrically conductive PCB finishing provides an electrically conductive material in the form of a layer that adapts to the surface of the hole. Accordingly, the electrically conductive PCB finishing provides a continuous path between the metallic substrate and one or more electrically conductive tracks.

In some embodiments, the hole is arranged in a part of the printed circuit board free of electrically conductive layer. Accordingly, the hole only traverses the at least one electrically insulating layer. This means that the printed circuit board may be directly provided with one or more regions with no electrically conductive layer so that the hole needs only to traverse the at least one electrically insulating layer.

Alternatively, in some other embodiments, the hole further traverses the electrically conductive layer, and also the solder mask (if there is any). In this way, the metallic substrate of the printed circuit board may be exposed so that the electrically conductive material may electrically connect the metallic substrate to a track of the electrically conductive layer.

The metallic substrate is connected to a common electric potential of the electrical device. For example, the metallic substrate may be grounded (i.e. connected to a ground), in which case the electrical device may be shielded against electrostatic discharges and feature an enhanced protection against radiated electromagnetic fields. The electrically conductive track or tracks are, thus, also grounded due to their electrical connection to the metallic substrate.

In some embodiments, the electrical device further comprises a metallic heatsink attached to the metallic substrate. The metallic heatsink may improve the dissipation of heat produced by the electrical device or any device connected to the electrical device such as, for instance, light sources. In addition, in some of these embodiments, the electrical device may further comprise a layer of a thermally conductive material interposed between the metallic heatsink and the metallic substrate. This layer may enhance the heat conduction so that more heat may be transferred to the metallic heatsink thereby improving the heat dissipation of the electrical device.

A second aspect of the invention relates to a lighting device for a motor vehicle, comprising:
an electrical device according to the first aspect of the invention; and
a light source electrically connected to the electrical device.

The lighting device may advantageously use the electrical device for being electrically powered and for dissipating part of the heat produced while it provides light.

A further aspect of the invention relates to an automotive lamp comprising a lighting device according to the second aspect of the invention.

The automotive lamp may be one of: a headlamp, a turn signal lamp, and a tail lamp.

A fourth aspect of the invention relates to a method for producing an electrical device for a lighting device as set forth in claim 8.

In some embodiments, the electrically conductive material comprises solder paste.

The step of adhering the electrically conductive material to the electrically conductive layer comprises applying, to the printed circuit board, an electrically conductive PCB finishing like, for instance, HASL, ENIG, or immersion tin.

In some embodiments, the method further comprises adhering the electrically conductive material to the metallic substrate. The electrical connection may be more reliable if the conductive material is adhered to the metallic substrate.

In some embodiments, the hole further traverses the electrically conductive layer. And in those embodiments in which the printed circuit board further comprises a solder mask, the hole may also traverse the solder mask.

In some embodiments, the method further comprises providing a metallic heatsink; and attaching the metallic heatsink to the metallic substrate. In some of these embodiments, the method further comprises interposing a layer of a thermally conductive material between the metallic heatsink and the metallic substrate.

The method further comprises connecting the metallic substrate to an electric potential or a ground.

Further, similar advantages as described for the first aspect of the invention may also be applicable to this aspect of the invention.

Another aspect of the invention relates to a method for producing a lighting device, the method comprising:
producing an electrical device according to the fourth aspect of the invention;
providing a light source; and
electrically connecting the light source to the electrical device.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figures 1A-1F illustrate a method for producing an electrical device in accordance with an embodiment of the invention.
Figures 2A-2E illustrate a method for producing an electrical device in accordance with another embodiment of the invention.
Figure 3 shows an electrical device in accordance with an embodiment of the invention.
Figure 4 shows a lighting device including an electrical device in accordance with an embodiment of the invention.

### DESCRIPTION OF A WAY OF CARRYING OUT THE INVENTION

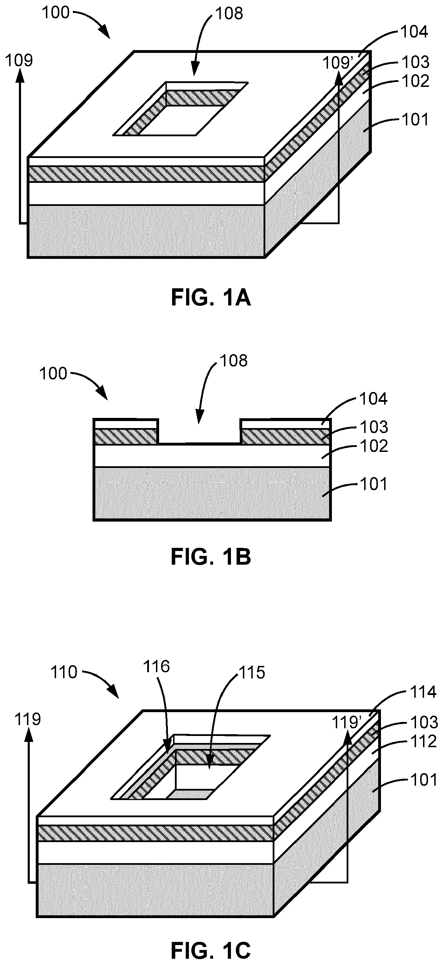

Figures 1A-1F show a method for producing an electrical device 120.

The method comprises providing a printed circuit board 100 as shown in Figures 1A-1B. The printed circuit board 100 comprises a metallic substrate 101, an electrically insulating layer 102, an electrically conductive layer 103, and a solder mask 104 attached to the electrically conductive layer 103. The printed circuit board 100 may be configured as an insulated metal substrate printed circuit board or IMS PCB.

The electrically conductive layer 103 defines electrically conductive tracks (not illustrated) which may be accessed in areas free of solder mask 104 (not illustrated) that expose the tracks, that is, the electrically conductive layer 103. Electronic components may be soldered in these areas, for instance using solder paste and a reflow soldering procedure.

Further, the electrically conductive layer 103 and the solder mask 104 are both provided with respective slots, that is, with regions 108 free of material. The printed circuit board 100 may be manufactured with the electrically conductive layer 103 and solder mask 104 already slotted if, for example, it is known in advance that no electronics need to be placed in that part of the PCB and that no electrically conductive tracks go through said slots. This may be the case of an electrical device that is to be manufactured in mass production, for example, since the layout of the electrically conductive layer is already known.

Even though the illustrated slots have closed ends, they may also be open-ended, that is, they may have one or more sides delimited by the sides or edges of the printed circuit board 100.

The electrically conductive layer 103 generally comprises copper, whereas the metallic substrate 101 generally comprises aluminum or copper. It is clear, however, that they may comprise other materials which are also electrically conductive, for instance silver or gold.

Figure 1B is a sectional view of the printed circuit board 100 taken along line 109-109'. It can be observed that even though there is a part 108 free of electrically conductive layer 103, the electrically insulating layer 102 is sandwiched between the metallic substrate 101 and the electrically conductive layer 103.

Figures 1C-1D show a step of providing a hole 115 in the printed circuit board 100 of Figures 1A-1B.

The hole 115 traverses the electrically insulating layer 102 thereby altering the shape of the electrically insulating layer 112. Since the hole 115 is provided in the region 108 free of electrically conductive layer 103, it is not necessary to alter the shape of said electrically conductive layer 103.

By providing the hole 115, the metallic substrate 101 is exposed. As an electrically conductive material will be provided such that at least part is within the hole, in order to provide a solid electrical connection, preferably the part of the solder mask 104 that is proximate to the hole 115 (in this case, the region 108) is removed. The modified solder mask 114 leaves part 116 of the electrically conductive layer 103 exposed and, therefore, permits that conductive material may be adhered to part of the top surface of the conductive layer 103.

A HASL, an ENIG, an immersion tin, an organic solderability preservative (OSP), or another PCB finishing treatments known in the art is applied to the printed circuit board 110.

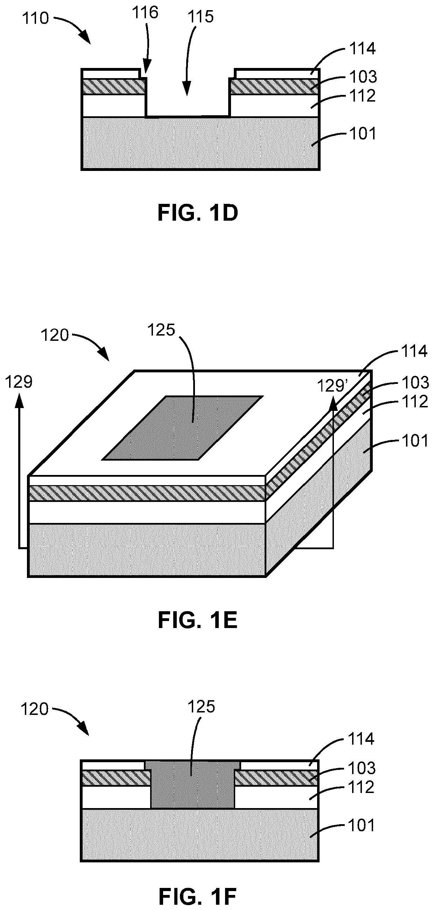

Figure 1D is a sectional view of the printed circuit board 110 with the hole 115 taken along line 119-119'.

Figures 1E-1F show a step of providing an electrically conductive material 125 having at least a part within the hole 115 and such that the electrically conductive material 125 may adhere to the electrically conductive layer 103. The electrically conductive material 125 connects one or more electrically conductive tracks of the electrically conductive layer 103 to the metallic substrate 101. Therefore, the conductive material 125 is also in contact with the substrate 101; in some embodiments, the electrically conductive material 125 is adhered to the metallic substrate 101.

The electrically conductive material 125 may comprise solder paste with which part of the cavity comprising the hole 115 and the regions 108 is filled. The solder paste provides a continuous electrical path between the metallic substrate 101 and at least one selected part (e.g. at least one electrically conductive track) of the electrically conductive layer 103. Although not necessary, it is preferable to make the solder paste reach the exposed parts 116 in order to improve the robustness of the electrical connection. The solder paste in said exposed parts 116 may be adhered to the electrically conductive layer 103, for instance, as a result of a reflow process, or by means of a further soldering process, hence at the end the electrically conductive material 125 may be soldered to the electrically conductive layer 113 in the parts 116.

The solder paste may be melted, for instance, with a reflow process. If solder paste is also provided on the electrically conductive layer 113, the same reflow process melts that solder paste thereby soldering any electronic components provided on the surface of the electrically conductive layer 113 and/or the solder mask 114.

In some embodiments, a finish treatment such as HASL may adhere solder to part of the hole and the electrically conductive layer 103 and, thus, provide the electrical connection.

Figure 1F is a sectional view of the printed circuit board 120 with the electrically conductive material 125 taken along line 129-129'.

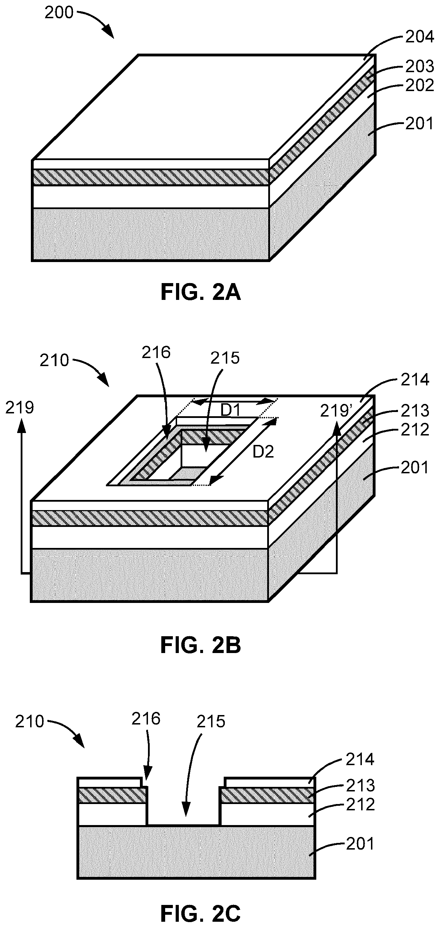

Figures 2A-2E show a method for producing an electrical device 220.

Figure 2A shows a step of providing a printed circuit board 200 that includes a metallic substrate 201, an electrically insulating layer 202, an electrically conductive layer 203, and a solder mask 204.

Figures 2B-2D show the printed circuit board 210 as it is provided with a hole 215.

Since the electrically conductive layer 203 and the solder mask 204 are not slotted, the hole 215 traverses the electrically insulating layer 202, the electrically conductive layer 203, and the solder mask 204.

The hole in the solder mask 214 may feature a diameter (any of the diameters D1 and D2) larger than that of the diameter of the hole in the electrically insulating layer 212 and the electrically conductive layer 213 and, hence, expose a part 216 of the electrically conductive layer 213.

Figure 2C is a sectional view of the printed circuit board 210 with the hole 215 taken along line 219-219'.

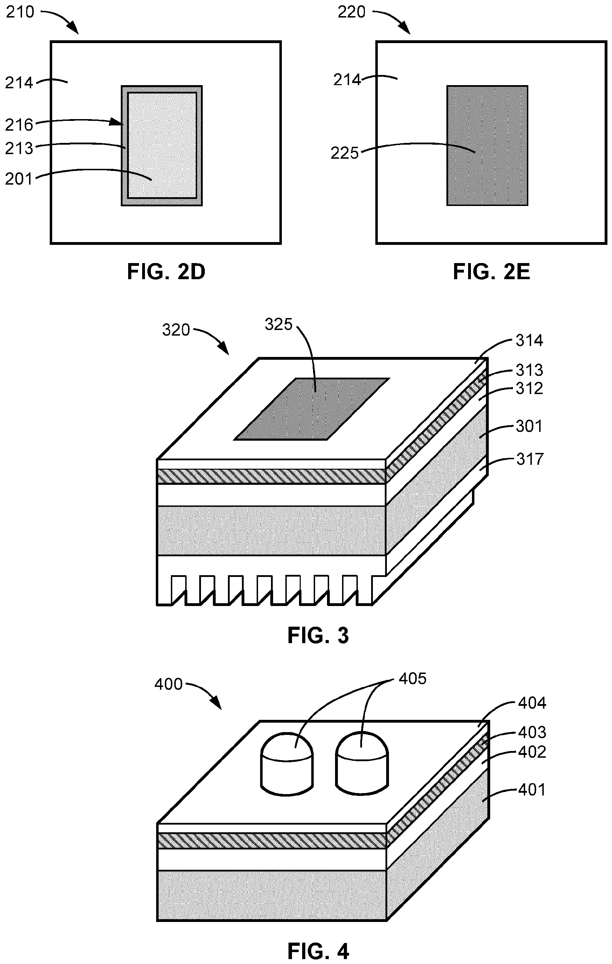

Figure 2D is a top view of the printed circuit board 210 with the hole 215.

Figure 2E is a top view of the printed circuit board 220 which includes an electrically conductive material 225 that connects at least one selected part (e.g. at least one electrically conductive track) of the electrically conductive layer 213 to the metallic substrate 201. The electrically conductive material 225 is also provided on top of part 216 so that the material 225 may be soldered to the electrically conductive layer 213 in order to improve the reliability of the electrical connection.

Figure 3 is an electrical device 320 in accordance with an embodiment of the invention. The electrical device 320 comprises a printed circuit board 310 in turn comprising a metallic substrate 301, an electrically insulating layer 312, an electrically conductive layer 313, and a solder mask 314.

The printed circuit board 310 features a cavity including a hole that at least traverses the electrically insulating layer 312. The hole may also traverse the electrically conductive layer 313 and the solder mask 314 (as in the embodiment of Figures 2A-2E), or the cavity may include regions of the layer 313 and the solder mask 314 which are free of material, that is, slots (as in the embodiment of Figures 1A-1F). In both cases, prior to providing an electrically conductive material 325, the printed circuit board has the metallic substrate 301 exposed thereon.

The electrically conductive material 325 (e.g. solder paste) is added to the cavity such that it is in contact with or adhered to the metallic substrate 301, and such that it may adhere to the electrically conductive layer 313.

The electrical device 320 further comprises a metallic heatsink 317 attached to the metallic substrate 301, for instance using solder paste.

In some embodiments, the metallic heatsink 317 is attached to the metallic substrate 301 such that a layer (not illustrated) is interposed between the metallic heatsink 317 and the metallic substrate 301, said layer being, for example, thermal grease that enhances heat conduction.

Figure 4 shows a lighting device 400 including an electrical device in accordance with an embodiment of the invention.

The electrical device comprises a printed circuit board 410 including a metallic substrate 401, an electrically insulating layer 402, an electrically conductive layer 403 and a solder mask 404. Although it is not illustrated, the printed circuit board 410 also includes a hole, and an electrically conductive material adhered to the electrically conductive layer 403 and having at least one part inside the hole. The electrically conductive material provides an electrical connection between the metallic substrate 401 and one or more electrically conductive tracks defined by the electrically conductive layer 403.

The lighting device 400 further comprises light sources 405 electrically coupled to the electrical device. The light sources 405 may be, for example, semiconductor light-emitting devices such as LEDs.

Aside from the printed circuit board 410 of the electrical device, the light sources 405 may also include one or more printed circuit boards (not illustrated).

The electrical device may be configured to supply power to the light sources 405 so that they may emit light, and to dissipate part of the heat produced by said light sources 405.

For illustrative purposes only, the layers of any of Figures 1A-1F, 2A-2E, 3and 4 have been represented with different colors and a striped pattern. Similarly, the thicknesses of any layers depicted therein may be out of proportion.

The holes 115, 215 illustrated feature a rectangular shape, however it is clear that holes with other shapes may also be provided without departing from the scope of the invention.

Even though the term "electrically conductive track(s)" has been used throughout the entire description of the invention, it is clear that the electrically conductive layer may define electrically conductive regions or parts which not necessarily are shaped as a track.

The invention is also not limited to printed circuit boards comprising only a single electrically conductive layer, and a single electrically insulating layer. Accordingly, the PCBs may include a first electrically conductive layer on top of a first electrically insulating layer, these being on top of a pair formed by a second electrically conductive layer on top of a second electrically insulating layer, and a metallic substrate beneath the second electrically insulating layer; optionally, the printed circuit board may also include a solder mask on top of the first electrically conductive layer.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. Electrical device (120,220,320) for a lighting device (400), comprising:
a printed circuit board (100,110,200,210,310,410) comprising at least one electrically insulating layer (102,112,202,212,312,402), a metallic substrate (101,201,301,401), and an electrically conductive layer (103,203,213,313,403) defining electrically conductive tracks, the at least one electrically insulating layer (102,112,202,212,312,402) being sandwiched between the metallic substrate (101,201,301,401) and the electrically conductive layer (103,203,213,313,403);
wherein
the printed circuit board (110,210,310,410) further comprises a hole (115,215) at least traversing the at least one electrically insulating layer (112,212,312,402); and
the printed circuit board (110,210,310,410) further comprises an electrically conductive material (125,225,325) having at least one part within the hole (115,215), the electrically conductive material (125,225,325) being adhered to the electrically conductive layer (103, 213,313,403) so as to electrically connect at least one of the electrically conductive tracks to the metallic substrate (101,201,301,401),
the electrical device being **characterized in that**
the electrically conductive material (125,225,325) comprises a layer produced by an electrically conductive PCB finishing; and **in that**
the metallic substrate (101,201,301,401) is connected to an electric potential or a ground.

2. Electrical device (120,220,320) according to claim 1, wherein the electrically conductive material (125,225,325) comprises solder paste.

3. Electrical device (120,220,320) according to any of claims 1-2, wherein the electrically conductive material (125,225,325) is further adhered to the metallic substrate (101,201,301,401).

4. Electrical device (220,320) according to any of claims 1-3, wherein the hole (115,215) further traverses the electrically conductive layer (213,313).

5. Electrical device (120,220,320) according to any of claims 1-4, further comprising a metallic heatsink (317) attached to the metallic substrate (101,201,301,401); and, optionally, a layer of a thermally conductive material interposed between the metallic heatsink (317) and the metallic substrate (101,201,301,401).

6. Lighting device (400) for a motor vehicle, comprising:
an electrical device (120,220,320) according to any of claims 1-5; and
a light source (405) electrically connected to the electrical device (120,220,320).

7. Automotive lamp comprising a lighting device (400) according to claim 6, the automotive lamp being one of: a headlamp, a turn signal lamp, and a tail lamp.

8. Method for producing an electrical device (120,220,320) for a lighting device (400), the method comprising:
providing a printed circuit board (100,110,200,210,310,410) comprising at least one electrically insulating layer (102,112,202,212,312,402), a metallic substrate (101,201,301,401), and an electrically conductive layer (103,203,213,313,403) defining electrically conductive tracks, the at least one electrically insulating layer (102,112,202,212,312,402) being sandwiched between the metallic substrate (101,201,301,401) and the electrically conductive layer (103,203,213,313,403);
providing a hole (115,215) in the printed circuit board (110,210,310,410) at least traversing the at least one electrically insulating layer (112,212,312,402);
providing an electrically conductive material (125,225,325) such that at least one part is within the hole (115,215); and
adhering the electrically conductive material (125,225,325) to the electrically conductive layer (103,203,213,313,403) so as to electrically connect at least one of the electrically conductive tracks to the metallic substrate (101,201,301,401),
the method being **characterized in that**
the step of adhering the electrically conductive material (125,225,325) to the electrically conductive layer comprises applying an electrically conductive PCB finishing to the printed circuit board (110,210,310,410); and **in that**
the method further comprises the step of connecting the metallic substrate (101,201,301,401) to an electric potential or a ground.

9. Method according to claim 8, wherein the electrically conductive material (125,225,325) comprises solder paste.

10. Method according to any of claims 8-9, wherein the hole (115,215) further traverses the electrically conductive layer (213,313).

11. Method according to any of claims 8-10, further comprising:
providing a metallic heatsink (317);
attaching the metallic heatsink (317) to the metallic substrate (101,201,301,401); and
optionally, interposing a layer of a thermally conductive material between the metallic heatsink (317) and the metallic substrate (101,201,301,401).

12. Method for producing a lighting device (400), the method comprising:
producing an electrical device (120,220,320) according to any of claims 8-11;
providing a light source (405); and
electrically connecting the light source (405) to the electrical device (120,220,320).

## Patentansprüche

1. Elektrische Vorrichtung (120, 220, 320) für eine Beleuchtungsvorrichtung (400), umfassend:
eine gedruckte Leiterplatte (100, 110, 200, 210, 310, 410), die mindestens eine elektrisch isolierende Schicht (102, 112, 202, 212, 312, 402), ein metallisches Substrat (101, 201, 301, 401) und eine elektrisch leitende Schicht (103, 203, 213, 313, 403), die elektrisch leitende Bahnen definiert, umfasst, wobei die mindestens eine elektrisch isolierende Schicht (102, 112, 202, 212, 312, 402) zwischen dem metallischen Substrat (101, 201, 301, 401) und der elektrisch leitenden Schicht (103, 203, 213, 313, 403) sandwichartig angeordnet ist;
wobei
die gedruckte Leiterplatte (110, 210, 310, 410) ferner ein Loch (115, 215) umfasst, das die mindestens eine elektrisch isolierende Schicht (112, 212, 312, 402) durchläuft; und
die gedruckte Leiterplatte (110, 210, 310, 410) ferner ein elektrisch leitendes Material (125, 225, 325) umfasst, von dem sich zumindest ein Teil innerhalb des Lochs (115, 215) befindet, wobei das elektrisch leitende Material (125, 225, 325) an die elektrisch leitende Schicht (103, 213, 313, 403) geklebt ist, um mindestens eine der elektrisch leitenden Bahnen mit dem metallischen Substrat (101, 201, 301, 401) elektrisch zu verbinden, wobei die elektrische Vorrichtung **dadurch gekennzeichnet ist, dass**
das elektrisch leitende Material (125, 225, 325) eine Schicht umfasst, die durch ein elektrisch leitendes PCB-Endfinish hergestellt ist; und dadurch, dass
das metallische Substrat (101, 201, 301, 401) mit einem elektrischen Potenzial oder einer Masse verbunden ist.

2. Elektrische Vorrichtung (120, 220, 320) nach Anspruch 1, wobei das elektrisch leitende Material (125, 225, 325) Lötpaste umfasst.

3. Elektrische Vorrichtung (120, 220, 320) nach einem der Ansprüche 1-2, wobei das elektrisch leitende Material (125, 225, 325) ferner an das metallische Substrat (101, 201, 301, 401) geklebt ist.

4. Elektrische Vorrichtung (220, 320) nach einem der Ansprüche 1-3, wobei das Loch (115, 215) ferner die elektrisch leitende Schicht (213, 313) durchläuft.

5. Elektrische Vorrichtung (120, 220, 320) nach einem der Ansprüche 1-4, ferner umfassend eine metallische Wärmesenke (317), die an dem metallischen Substrat (101, 201, 301, 401) angebracht ist; und, optional, eine Schicht eines thermisch leitenden Materials, die zwischen der metallischen Wärmesenke (317) und dem metallischen Substrat (101, 201, 301, 401) angeordnet ist.

6. Beleuchtungsvorrichtung (400) für ein Kraftfahrzeug, umfassend:
eine elektrische Vorrichtung (120, 220, 320) nach einem der Ansprüche 1-5; und
eine Lichtquelle (405), die mit der elektrischen Vorrichtung (120, 220, 320) elektrisch verbunden ist.

7. Kraftfahrzeugleuchte, umfassend eine Beleuchtungsvorrichtung (400) nach Anspruch 6, wobei die Kraftfahrzeugleuchte eines von Folgendem ist: eine Scheinwerferleuchte, eine Fahrtrichtungsanzeigeleuchte und eine Rückleuchte.

8. Verfahren zum Herstellen einer elektrischen Vorrichtung (120, 220, 320) für eine Beleuchtungsvorrichtung (400), wobei das Verfahren umfasst:
Bereitstellen einer gedruckten Leiterplatte (100, 110, 200, 210, 310, 410), die mindestens eine elektrisch isolierende Schicht (102, 112, 202, 212, 312, 402), ein metallisches Substrat (101, 201, 301, 401) und eine elektrisch leitende Schicht (103, 203, 213, 313, 403), die elektrisch leitende Bahnen definiert, umfasst, wobei die mindestens eine elektrisch isolierende Schicht (102, 112, 202, 212, 312, 402) zwischen dem metallischen Substrat (101, 201, 301, 401) und der elektrisch leitenden Schicht (103, 203, 213, 313, 403) sandwichartig angeordnet ist;
Bereitstellen eines Lochs (115, 215) in der gedruckten Leiterplatte (110, 210, 310, 410), das die mindestens eine elektrisch isolierende Schicht (112, 212, 312, 402) durchläuft;
Bereitstellen eines elektrisch leitenden Materials (125, 225, 325) derart, dass sich zumindest ein Teil innerhalb des Lochs (115, 215) befindet; und
Kleben des elektrisch leitenden Materials (125, 225, 325) an die elektrisch leitende Schicht (103, 203, 213, 313, 403), um mindestens eine der elektrisch leitenden Bahnen mit dem metallischen Substrat (101, 201, 301, 401) elektrisch zu verbinden,
wobei das Verfahren **dadurch gekennzeichnet ist, dass**
der Schritt zum Kleben des elektrisch leitenden Materials (125, 225, 325) an die elektrisch leitende Schicht Aufbringen eines elektrisch leitenden PCB-Finishs auf die gedruckte Leiterplatte (110, 210, 310, 410) umfasst; und dadurch, dass
das Verfahren ferner den Schritt Verbinden des metallischen Substrats (101, 201, 301, 401) mit einem elektrischen Potenzial oder einer Masse umfasst.

9. Verfahren nach Anspruch 8, wobei das elektrisch leitende Material (125, 225, 325) Lötpaste umfasst.

10. Verfahren nach einem der Ansprüche 8-9, wobei das Loch (115, 215) ferner die elektrisch leitende Schicht (213, 313) durchläuft.

11. Verfahren nach einem der Ansprüche 8-10, ferner umfassend:
Bereitstellen einer metallischen Wärmesenke (317);
Anbringen der metallischen Wärmesenke (317) an dem metallischen Substrat (101, 201, 301, 401); und
optional, Anordnen einer Schicht eines thermisch leitenden Materials zwischen der metallischen Wärmesenke (317) und dem metallischen Substrat (101, 201, 301, 401).

12. Verfahren zum Herstellen einer Beleuchtungsvorrichtung (400), wobei das Verfahren umfasst:
Herstellen einer elektrischen Vorrichtung (120, 220, 320) nach einem der Ansprüche 8-11;
Bereitstellen einer Lichtquelle (405); und
elektrisches Verbinden der Lichtquelle (405) mit der elektrischen Vorrichtung (120, 220, 320).

## Revendications

1. Dispositif électrique (120, 220, 320) pour un dispositif d'éclairage (400), comprenant :
une carte de circuit imprimé (100, 110, 200, 210, 310, 410) comprenant au moins une couche électriquement isolante (102, 112, 202, 212, 312, 402), un substrat métallique (101, 201, 301, 401), et une couche électriquement conductrice (103, 203, 213, 313, 403) définissant des pistes électriquement conductrices, l'au moins une couche électriquement isolante (102, 112, 202, 212, 312, 402) étant intercalée entre le substrat métallique (101, 201, 301, 401) et la couche électriquement conductrice (103, 203, 213, 313, 403) ;
dans lequel
la carte de circuit imprimé (110, 210, 310, 410) comprend en outre un trou (115, 215) traversant au moins l'au moins une couche électriquement isolante (112, 212, 312, 402) ; et
la carte de circuit imprimé (110, 210, 310, 410) comprend en outre un matériau électriquement conducteur (125, 225, 325) ayant au moins une partie à l'intérieur du trou (115, 215), le matériau électriquement conducteur (125, 225, 325) étant lié à la couche électriquement conductrice (103, 213, 313, 403) de manière à raccorder électriquement au moins une des pistes électriquement conductrices au substrat métallique (101, 201, 301, 401),
le dispositif électrique étant **caractérisé en ce que** le matériau électriquement conducteur (125, 225, 325) comprend une couche produite par une finition de PCB électriquement conductrice ; et **en ce que**
le substrat métallique (101, 201, 301, 401) est raccordé à un potentiel électrique ou une terre.

2. Dispositif électrique (120, 220, 320) selon la revendication 1, dans lequel le matériau électriquement conducteur (125, 225, 325) comprend de la pâte à braser.

3. Dispositif électrique (120, 220, 320) selon l'une quelconque des revendications 1 et 2, dans lequel le matériau électriquement conducteur (125, 225, 325) est en outre lié au substrat métallique (101, 201, 301, 401).

4. Dispositif électrique (220, 320) selon l'une quelconque des revendications 1 à 3, dans lequel le trou (115, 215) traverse en outre la couche électriquement conductrice (213, 313).

5. Dispositif électrique (120, 220, 320) selon l'une quelconque des revendications 1 à 4, comprenant en outre un dissipateur thermique métallique (317) fixé au substrat métallique (101, 201, 301, 401) et, éventuellement, une couche d'un matériau thermiquement conducteur intercalée entre le dissipateur thermique métallique (317) et le substrat métallique (101, 201, 301, 401).

6. Dispositif d'éclairage (400) pour un véhicule à moteur, comprenant :
un dispositif électrique (120, 220, 320) selon l'une quelconque des revendications 1 à 5 ; et
une source de lumière (405) électriquement raccordée au dispositif électrique (120, 220, 320).

7. Lampe automobile comprenant un dispositif d'éclairage (400) selon la revendication 6, la lampe automobile étant soit un phare, soit un clignotant, soit un feu arrière.

8. Procédé de production d'un dispositif électrique (120, 220, 320) pour un dispositif d'éclairage (400), le procédé comprenant :
l'obtention d'une carte de circuit imprimé (100, 110, 200, 210, 310, 410) comprenant au moins une couche électriquement isolante (102, 112, 202, 212, 312, 402), un substrat métallique (101, 201, 301, 401), et une couche électriquement conductrice (103, 203, 213, 313, 403) définissant des pistes électriquement conductrices, l'au moins une couche électriquement isolante (102, 112, 202, 212, 312, 402) étant intercalée entre le substrat métallique (101, 201, 301, 401) et la couche électriquement conductrice (103, 203, 213, 313, 403) ;
le creusement d'un trou (115, 215) dans la carte de circuit imprimé (110, 210, 310, 410), traversant au moins l'au moins une couche électriquement isolante (112, 212, 312, 402) ; et
l'application d'un matériau électriquement conducteur (125, 225, 325) de telle sorte qu'au moins une partie soit à l'intérieur du trou (115, 215) ; et
la liaison du matériau électriquement conducteur (125, 225, 325) à la couche électriquement conductrice (103, 203, 213, 313, 403) de manière à raccorder électriquement au moins une des pistes électriquement conductrices au substrat métallique (101, 201, 301, 401),
le procédé étant **caractérisé en ce que**
l'étape de liaison du matériau électriquement conducteur (125, 225, 325) à la couche électriquement conductrice comprend l'application d'une finition de PCB électriquement conductrice à la carte de circuit imprimé (110, 210, 310, 410) ; et **en ce que**
le procédé comprend en outre l'étape de raccordement du substrat métallique (101, 201, 301, 401) à un potentiel électrique ou une terre.

9. Procédé selon la revendication 8, dans lequel le matériau électriquement conducteur (125, 225, 325) comprend de la pâte à braser.

10. Procédé selon l'une quelconque des revendications 8 et 9, dans lequel le trou (115, 215) traverse en outre la couche électriquement conductrice (213, 313).

11. Procédé selon l'une quelconque des revendications 8 à 10, comprenant en outre :
l'obtention d'un dissipateur thermique métallique (317) ;
la fixation du dissipateur thermique métallique (317) au substrat métallique (101, 201, 301, 401) ; et
éventuellement, l'intercalation d'une couche d'un matériau thermiquement conducteur entre le dissipateur thermique métallique (317) et le substrat métallique (101, 201, 301, 401).

12. Procédé de production d'un dispositif d'éclairage (400), le procédé comprenant :
la production d'un dispositif électrique (120, 220, 320) selon l'une quelconque des revendications 8 à 11 ;
l'obtention d'une source de lumière (405) ; et
le raccordement électrique de la source de lumière (405) au dispositif électrique (120, 220, 320).
